# FASCICULE DE BREVET EUROPEEN

(11) **EP 0 822 681 B1**
(45) Date de publication et mention de la délivrance du brevet: **21.05.2003**
(21) Numéro de dépôt: 97401809.5
(22) Date de dépôt: 28.07.1997
(51) Int. Cl.: H04L 1/20, H03M 13/00, G10L 13/04, G10L 15/04

(54) **Procédé et dispositif d'estimation de la qualité de blocs d'information reçus via un système de transmission utilisant un codage par blocs**
Verfahren und System zur Schätzung der Qualität von empfangenen Informationsblöcken über ein Übertragungssystem mit Verwendung von Blockkodierung
Method and system for estimating the quality of blocks of information received via a transmission system using block coding

(30) Priorité: 29.07.1996 FR 9609511
(43) Date de publication de la demande: 04.02.1998
(73) Titulaire: ALCATEL, 75382 Paris Cédex 08 (FR)
(72) Inventeur: Latawiec, Régis, 78230 Le Pecq (FR)
(74) Mandataire: El Manouni, Josiane

(56) Documents cités:
- EP-A- 0 603 854
- WO-A-95/08152
- WO-A-95/30282
- US-A- 5 073 940
- US-A- 5 253 126
- US-A- 5 255 343
- US-A- 5 309 443
- US-A- 5 321 705
- US-A- 5 502 713

## Description

La présente invention concerne d'une manière générale les systèmes de transmission numérique dans lesquels est mis en oeuvre, en émission, un codage dit par blocs.

La présente invention concerne ainsi notamment les systèmes de radiotéléphonie, notamment le système GSM ("Global System for Mobile Communications"), dans lesquels est mis en oeuvre, en émission, un codage réducteur de débit réalisé, de manière connue, en extrayant, sur des intervalles de temps de durée déterminée (typiquement 20 ms) pendant lesquels on peut considérer que les caractéristiques des signaux de parole sont stables, des paramètres représentatifs de ces signaux de parole, et en transmettant ces paramètres, plutôt que les signaux eux-mêmes, dans des entités appelées blocs, ou aussi trames de phonie.

Dans de tels systèmes,on effectue, en réception, une estimation de la nature acceptable ou non acceptable des blocs reçus, afin de remplacer des blocs estimés non acceptables par des blocs obtenus en réalisant une interpolation de ces blocs avec des blocs précédents estimés acceptables, et de réduire parallèlement le volume sonore, jusqu'à couper complètement ce volume sonore au bout d'un certain temps si les blocs continuent d'être non acceptables.

Un bloc reçu est d'une manière générale estimé non acceptable lorsque sa qualité de transmission (déterminée suivant des méthodes connues, notamment en utilisant des techniques de codage canal) est insuffisante.

Il est ainsi connu, pour réaliser une estimation de la nature acceptable ou non acceptable de blocs reçus par un récepteur de radiotéléphone du type GSM, d'utiliser deux paramètres dont l'un est constitué par le résultat de la comparaison, par rapport à une valeur seuil, du nombre de bits erronés reçus par bloc, ce nombre de bits erronés étant estimé grâce à un premier type de codage canal, constitué par un codage correcteur d'erreurs appliqué à l'ensemble des bits d'un bloc, et dont l'autre est constitué par une indication de détection d'erreurs obtenue grâce à un deuxième type de codage canal, constitué par un codage détecteur d'erreurs appliqué seulement à ceux des bits d'un bloc qui sont considérés comme les plus importants à protéger (bits dits de classe Ia).

Il est en outre connu de réaliser une combinaison du type "ET logique" entre ces deux paramètres, de sorte qu'un bloc n'est déclaré acceptable que si chacun de ces deux paramètres est dans un état jugé acceptable, alors qu'un bloc est déclaré non acceptable dès lors qu'un seul de ces deux paramètres est dans un état jugé non acceptable.

Un tel dispositif est décrit par exemple dans le document WO 95/08152.

Le brevet US 5 502 713 décrit un autre dispositif d'estimation d'erreur dans un système de radiocommunication.

Un problème se pose dans un tel dispositif, qui est que d'un bloc à l'autre les variations du nombre de bits erronés peuvent être très importantes. Ces variations, lorsqu'elles se produisent autour de ladite valeur seuil, sont susceptibles de provoquer des alternances bloc acceptable/bloc non acceptable, qui sont notamment à l'origine d'un bruit désagréable qui nuit au confort d'écoute.

La présente invention a notamment pour but d'éviter cet inconvénient.

La présente invention a ainsi pour objet un procédé d'estimation de la nature acceptable ou non acceptable de blocs d'information reçus via un système de transmission utilisant un codage par blocs, cette estimation s'effectuant en fonction de plusieurs paramètres relatifs à la qualité de transmission des blocs d'information reçus, dont au moins un, dit premier paramètre, est susceptible d'osciller autour d'une valeur seuil, entre un état acceptable et un état non acceptable, lorsque les conditions de transmission commencent à se dégrader, et au moins un autre, dit deuxième paramètre, présente deux états, acceptable et non acceptable, plus stables, ce procédé étant essentiellement caractérisé en ce que, dans le cas d'un bloc précédent estimé acceptable, on attend que ledit deuxième paramètre soit dans un état non acceptable pour estimer que le bloc présent est non acceptable.

La présente invention a également pour objet un dispositif pour la mise en oeuvre d'un tel procédé.

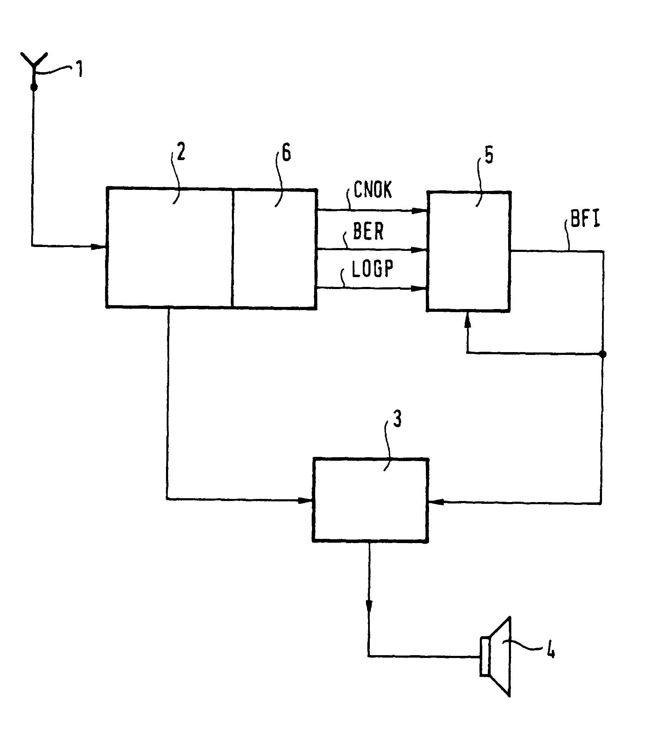

D'autres objets et caractéristiques de la présente invention apparaîtront à la lecture de la description suivante d'un exemple de réalisation, faite en relation avec la figure ci-annexée illustrant un récepteur de radiotéléphone tel que notamment un récepteur GSM incluant un procédé et un dispositif suivant l'invention.

Le récepteur illustré sur cette figure reçoit, comme rappelé dans ce qui précède, des blocs d'information obtenus en faisant successivement subir, à des signaux de parole numérisés, un codage par blocs destiné à réduire le débit de ces signaux, puis un codage canal destiné à procurer une protection contre les erreurs de transmission ainsi qu'à déterminer, en réception, la qualité de transmission.

Dans ce récepteur les signaux reçus par une antenne 1 sont, de manière connue, appliqués à des moyens 2 de démodulation et de décodage canal.

Les blocs issus des moyens 2 sont, également de manière connue, appliqués à des moyens 3, comportant notamment des moyens de décodage par blocs, et destinés à fournir des signaux de parole à appliquer à un haut-parleur 4.

Ce récepteur comporte en outre des moyens 5 d'estimation de la nature acceptable ou non acceptable des blocs reçus, ces moyens 5 fournisant un signal noté BFI repésentant le résultat de cette estimation, ce signal BFI étant appliqué aux moyens 3 afin de remplacer, pour la fourniture des signaux de parole à appliquer au haut-parleur, des blocs non acceptables par des blocs obtenus en réalisant une interpolation de ces blocs avec des blocs précédents estimés acceptables, et de réduire parallèlement le volume sonore.

Pour estimer la qualité acceptable ou non acceptable d'un bloc incident reçu, ces moyens 5 opèrent sous la commande de signaux représentant des paramètres issus de moyens 6 d'estimation de la qualité de transmission de ce bloc, ainsi que sous la commande du signal BFI représentant le résultat de l'estimation de la nature acceptable ou non acceptable du bloc reçu précédemment.

Dans l'exemple de réalisation considéré, un de ces paramètres, noté BER, est constitué par le résultat de la comparaison par rapport à un seuil, du nombre de bits erronés reçus par bloc, ce nombre de bits erronés étant estimé, de manière connue, grâce à un premier type de codage canal constitué par un codage correcteur d'erreurs appliqué à l'ensemble des bits d'un bloc.

Dans l'exemple de réalisation considéré, un autre de ces paramètres, noté CNOK, est constitué par une indication de détection d'erreurs obtenue, de manière connue, grâce à un deuxième type de codage canal constitué par un codage détecteur d'erreurs appliqué seulement à ceux des bits d'un bloc qui sont considérés comme les plus importants à protéger (bits dits de classe Ia).

Dans l'exemple de réalisation considéré, un autre de ces paramètres, noté LOGP, est constitué par un indicateur de confiance dans l'opération de décision effectuée, sur chaque bloc, par les moyens 2 de démodulation et de décodage canal, cet indicateur de confiance étant obtenu suivant la technique connue dite de "soft decision".

Les paramètres BER et LOGP sont en l'occurrence susceptibles d'osciller autour d'une valeur seuil (notée respectivement SBER et SLOGP) entre un état acceptable et un état non acceptable, lorsque les conditions de transmission commencent à se dégrader, et sont à ce titre appelés ici premiers paramètres, alors que le paramètre CNOK présente deux états, acceptable et non acceptable, plus stables, et est à ce titre appelé ici deuxième paramètre.

Suivant l'invention, les moyens 5 opèrent de façon à ce que, dans le cas d'un bloc précédent estimé acceptable, on attend que ledit deuxième paramètre (c'est-à-dire ici le paramètre CNOK) soit dans un état non acceptable pour estimer que le bloc présent est non acceptable (au lieu de prendre une telle décision seulement sur le passage de l'un desdits premiers paramètres dans un état non acceptable, comme cela est le cas dans l'art antérieur, rappelé plus haut, où ce premier paramètre est le paramètre BER).

De cette façon, on évite les alternances dans les décisions bloc acceptable/bloc non acceptable lorsque les conditions de transmission commencent à se dégrader, et on améliore ainsi le confort d'écoute.

En outre, dans le cas d'un bloc précédent non acceptable, on attend que l'ensemble des premier et deuxième paramètres soient dans des états acceptables pour décider que le bloc présent est acceptable.

Ainsi, dans l'exemple de réalisation considéré, et avec les notations suivantes:
- CNOK = 0: état acceptable
- CNOK = 1: état non acceptable
- BER < SBER: état acceptable
- BER > SBER: état non acceptable
- LOGP > SLOGP: état acceptable
- LOGP < SLOGP: état non acceptable
- BFI = 0: trame précédente acceptable
- BFI = 1: trame précédente non acceptable
ce procédé peut aussi être décrit de la façon suivante:
Si BFI = 1
alors :
   si ( CNOK = 0 et BER < SBER et LOGP > SLOGP)
   alors : BFI = 0
   sinon : BFI = 1
Si BFI = 0
alors:
   si ( CNOK = 1)
   alors : BFI = 1
   sinon : BFI = 0

Les moyens 5 opérant de la façon ainsi décrite peuvent être réalisés par une machine d'états, ou séquenceur, qui comporte ainsi, dans l'exemple de réalisation considéré:
- des moyens pour, dans le cas d'un bloc précédent acceptable, estimer que le bloc présent est non acceptable seulement si ledit deuxième paramètre est dans un état non acceptable
- des moyens pour, dans le cas d'un bloc précédent non acceptable, estimer que le bloc présent est acceptable si lesdits premiers et deuxième paramètres sont dans des états acceptables.

## Revendications

1. Procédé d'estimation de la nature acceptable ou non acceptable de blocs d'information reçus via un système de transmission utilisant un codage par blocs, cette estimation s'effectuant en fonction de plusieurs paramètres relatifs à la qualité de transmission des blocs d'information reçus, dont au moins un, dit premier paramètre (BER, LOGP), est susceptible d'osciller autour d'une valeur seuil, entre un état acceptable et un état non acceptable, lorsque les conditions de transmission commencent à se dégrader, et au moins un autre, dit deuxième paramètre (CNOK), présente deux états, acceptable et non acceptable, plus stables, **caractérisé en ce que**, dans le cas d'un bloc précédent estimé acceptable, on attend que ledit deuxième paramètre soit dans un état non acceptable pour estimer que le bloc présent est non acceptable.

2. Procédé selon la revendication 1, **caractérisé en ce que** dans le cas d'un bloc précédent estimé non acceptable, on attend que l'ensemble desdits premiers et deuxièmes paramètres soient dans des états acceptables pour estimer que le bloc présent est acceptable.

3. Procédé selon l'une des revendications 1 et 2, **caractérisé en ce que** ledit deuxième paramètre est constitué par le résultat de la comparaison par rapport à un seuil, du nombre de bits erronés reçus par bloc, ce nombre de bits erronés étant estimé grâce à un premier type de codage canal constitué par un codage correcteur d'erreurs appliqué à l'ensemble des bits d'un bloc.

4. Procédé selon l'une des revendications 1 à 3, **caractérisé en ce qu'**un desdits premiers paramètres est constitué par une indication de détection d'erreurs obtenue grâce à un deuxième type de codage canal constitué par un codage détecteur d'erreurs appliqué seulement à ceux des bits d'un bloc qui sont considérés comme les plus importants à protéger.

5. Procédé selon l'une des revendications 1 à 4, **caractérisé en ce qu'**un desdits premiers paramètres est constitué par un indicateur de confiance dans le résultat de l'opération de décision effectuée sur chaque bloc, en réception.

6. Dispositif récepteur de radiocommunication, comportant des moyens d'estimation de la nature acceptable ou non acceptable de blocs d'information reçus en fonction d'au moins deux paramètres relatifs à la qualité de transmission des blocs d'information reçus, dont au moins un, dit premier paramètre (BER, LOGP), est susceptible d'osciller autour d'une valeur seuil, entre un état acceptable et un état non acceptable, lorsque les conditions de transmission commencent à se dégrader, et au moins un autre, dit deuxième paramètre (CNOK), présente deux états, acceptable et non acceptable, plus stables, ce dipositif étant **caractérisé en ce qu'**il comporte des moyens qui, dans le cas d'un bloc précédent estimé acceptable, attend que ledit deuxième paramètre soit dans un état non acceptable pour estimer que le bloc présent est non acceptable.

## Patentansprüche

1. Verfahren zum Einschätzen der Brauchbarkeit oder Unbrauchbarkeit von Informationsblöcken, die über ein eine Blockcodierung verwendendes Übertragungssystem empfangen werden, wobei die Einschätzung in Abhängigkeit von mehreren die Übertragungsqualität der empfangenen Informationsblöcke betreffenden Parametern erfolgt, von denen wenigstens einer, als erster Parameter (BER, LOGP) bezeichnet, um einen Grenzwert zwischen einem brauchbaren Zustand und einem nicht brauchbaren Zustand schwanken kann, wenn die Übertragungsbedingungen beginnen, sich zu verschlechtern, und wenigstens ein anderer, sogenannter zweiter Parameter (CNOK) zwei Zustände, brauchbar oder nicht brauchbar, aufweist, die stabiler sind, **dadurch gekennzeichnet, dass** im Fall eines als brauchbar eingeschätzten vorhergehenden Blocks abgewartet wird, dass der zweite Parameter in einem nicht brauchbaren Zustand ist, um den vorliegenden Block als nicht brauchbar einzuschätzen.

2. Verfahren nach Anspruch 1, **dadurch gekennzeichnet, dass** im Falle der Einschätzung eines vorhergehenden Blocks als nicht brauchbar abgewartet wird, bis erster und zweiter Parameter beide in einem brauchbaren Zustand sind, um den vorliegenden Block als brauchbar einzuschätzen.

3. Verfahren nach einem der Ansprüche 1 und 2, **dadurch gekennzeichnet, dass** der zweite Parameter gebildet wird durch das Ergebnis des Vergleichs der Zahl von pro Block fehlerhaft empfangenen Bits mit einem Schwellwert, wobei diese Zahl von fehlerhaften Bits eingeschätzt wird mit Hilfe eines ersten Typs von Kanalcodierung, daß damit eine auf die Gesamtheit der Bits eines Blocks angewandte Fehlerkorrekturcodierung gebildet ist.

4. Verfahren nach einem der Ansprüche 1 bis 3, **dadurch gekennzeichnet, dass** einer der Parameter durch einen Fehlererfassungshinweis gebildet ist, der mit Hilfe eines zweiten Typs von Kanalcodierung erhalten wird, der duron eine Fehlerkorrekturcodierung gebildet wird, die nur auf diejenigen Bits eines Blocks angewendet wird, die als die am wichtigsten zu schützenden Bits angesehen werden.

5. Verfahren nach einem der Ansprüche 1 bis 4, **dadurch gekennzeichnet, dass** einer der ersten Parameter durch einen Zuverlässigkeitsindikator im Ergebnis der an jedem Block beim Empfang durchgeführten Entscheidungsoperation gebildet ist.

6. Funkkommunikationsempfängervorrichtung mit Mitteln zum Einschätzen der Brauchbarkeit oder Unbrauchbarkeit von empfangenen Informationsblöcken in Abhängigkeit von wenigstens zwei die Übertragungsqualität der empfangenen Informationsblöcke betreffenden Parametern, von denen wenigstens einer, als erster Parameter (BER, LOGP) bezeichnet, um einen Schwellwert zwischen einem brauchbaren und einem unbrauchbaren Zustand schwanken kann, wenn die Übertragungsbedingungen beginnen, sich zu verschlechtern, und wenigstens ein anderer, als zweiter Parameter (CNOK) bezeichnet, zwei Zustände, brauchbar und unbrauchbar aufweist, die stabiler sind, **dadurch gekennzeichnet, dass** sie Mittel umfasst, die im Falle eines vorhergehenden, als brauchbar eingeschätzten Blocks abwarten, dass der zweite Parameter in einem unbrauchbaren Zustand ist, um den vorliegenden Block als unbrauchbar einzuschätzen.

## Claims

1. A method of estimating the acceptable or unacceptable nature of blocks of information received via a transmission system using block coding, this estimation being effected as a function of a plurality of parameters relating to the transmission quality of the blocks of information received, of which at least one, referred to as the first parameter (BER, LOGP), is liable to oscillate about a threshold value, between an acceptable state and an unacceptable state, if transmission conditions begin to deteriorate, and at least one other of which, referred to as the second parameter (CNOK), has more stable acceptable and unacceptable states, which method is **characterized in that**, in the case of a preceding block estimated to be acceptable, it waits for said second parameter to be in an unacceptable state before estimating that the present block is unacceptable.

2. A method according to claim 1, **characterized in that** in the case of a preceding block estimated to be unacceptable, it waits for both said first and second parameters to be in an acceptable state before estimating that the present block is acceptable.

3. A method according to either claim 1 or claim 2, **characterized in that** said second parameter is the result of comparing to a threshold the number of erroneous bits received per block, as estimated by means of a first type of channel coding consisting of applying an error corrector code to all the bits of a block.

4. A method according to any of claims 1 to 3, **characterized in that** one of said first parameters is an indication of detection of errors obtained by means of a second type of channel coding consisting of applying an error detector code only to those of the bits of a block that are considered to be the most important to protect.

5. A method according to any of claims 1 to 4, **characterized in that** one of said first parameters is an indicator of confidence in the result of the decision operation applied to each block in the receiver.

6. A radio receiver device including means for estimating the acceptable or unacceptable nature of blocks of information received as a function of at least two parameters relating to the transmission quality of the blocks of information received, of which at least one, referred to as the first parameter (HER, LOGP) is liable to oscillate about a threshold value, between an acceptable state and an unacceptable state, when transmission conditions begin to deteriorate, and at least one other of which, referred to as the second parameter (CNOK), has more stable acceptable and unacceptable states, which device is **characterized in that** it includes means which, in the case of a preceding block estimated to be acceptable, wait for said second parameter to be in an unacceptable state before estimating that the present block is unacceptable.
